# EUROPÄISCHE PATENTSCHRIFT

(11) **EP 1 217 498 B1**
(45) Veröffentlichungstag und Bekanntmachung des Hinweises auf die Patenterteilung: **30.05.2007**
(21) Anmeldenummer: 01106972.1
(22) Anmeldetag: 21.03.2001
(51) Int. Cl.: G06F 1/04

(54) **Taktgeber zur Erzeugung eines im Frequenzspektrum verschliffenen Systemtaktes**
Clock with variable frequency control
Horloge possédant un contrôle de fréquence variable

(30) Priorität: 23.12.2000 DE 10065072
(43) Veröffentlichungstag der Anmeldung: 26.06.2002
(73) Patentinhaber: Micronas GmbH, 79108 Freiburg i. Br. (DE)
(72) Erfinder: Bock, Christian, Dr., 79108 Freiburg (DE)

(56) Entgegenhaltungen:
- EP-A- 0 715 408
- EP-A- 0 892 498
- DE-A1- 19 517 265

## Beschreibung

Die Erfindung betrifft einen Taktgeber zur Erzeugung eines im Frequenzspektrum verschliffenen Systemtaktes. Ein derartiger Taktgeber mit zugehörigem Verfahren ist beispielsweise in der eigenen Patentanmeldung DE 44 42 403 A1 oder EP 0715 408 A1 beschrieben. Ein Taktgenerator erzeugt dort einen im zeitlichen Mittel frequenzgenauen Systemtakt, indem ein in der Phase und Frequenz stabiler Ursprungstakt mittels eines Phasenmodulators in der Phase moduliert wird, wobei der Phasenmodulator mit Zufallszahlen aus einem Zufallszahlengenerator angesteuert wird.

Die Phasenabweichungen dürfen für die sichere Funktion des Systemtaktes in den praktischen Anwendungsfällen jedoch nicht zu groß sein, weil ansonsten bei sehr kurzen Taktphasen die verbleibende Verarbeitungszeit in einigen vom Systemtakt gesteuerten Schaltungsteilen nicht mehr ausreichend lang ist. Es sind daher Mindestphasen für den oberen oder unteren Taktzustand vorgegeben, die nicht unterschritten werden dürfen. Da man mit dem Systemtakt sowieso dicht an der technologischen Grenze arbeitet, um möglichst viele Funktionen pro Zeiteinheit durchführen zu können, ist eine deutliche Verkürzung der Taktphasen meist nicht möglich. Damit ist aber auch der Aussteuerbereich der Phasenmodulation begrenzt, wodurch der Verschleifungsbereich des Systemtaktes im Frequenzspektrums ebenfalls relativ begrenzt bleibt und damit auch die Wirkung auf die Reduktion der Störstrahlung.

Aufgabe der Erfindung ist es, einen verbesserten Taktgeber für einen Systemtakt anzugeben, mit dem eine größere Reduktion der Störstrahlung ermöglicht wird.

Die Aufgabe wird mit einem gattungsgemäßen Taktgenerator nach dem Oberbegriff des Anspruchs 1 im wesentlichen dadurch gelöst, daß zwischen dem Zufallszahlengenerator und dem Phasenmodulator ein Integrator eingefügt wird, der die Zufallszahlen integriert. Damit geht man von der zufallszahlengesteuerten Phasenmodulation auf eine zufallszahlengesteuerte Frequenzmodulation über. Andererseits verläßt man die Phasenmodulation auch nicht ganz, weil die jeweils generierten Phasensprünge direkt an die Zufallszahlen gekoppelt sind. Die maximale Höhe der Phasensprünge läßt sich so auf einfache Weise über den zugelassenen Bereich der Zufallszahlen kontrollieren. Werden die Zufallszahlen nicht als Pseudozufallszahlen mit begrenztem Zahlenbereich erzeugt, dann ist eine separate Bereichsbegrenzung erforderlich, die beispielsweise durch eine Nichtbeachtung des Überlaufes oder durch eine Modulo-Operation realisiert werden kann. Durch die Akkumulierung der einzelnen Phasensprünge nach der Erfindung, kann der zulässige Verschleifungsbereich wesentlich größer werden als bei einer reinen Phasenmodulation (=PM). Andererseits muß nun aber auch sichergestellt sein, daß die Phase und damit die Frequenz nicht zu weit von der Sollphase oder Sollfrequenz weglaufen. Bei der Akkumulierung der Zufallszahlen könnten ansonsten beliebige Werte erreicht werden und zwar unabhängig davon ob positive, negative oder positive und negative Zufallszahlen zugelassen werden. In jedem Fall muß eine geeignete Strategie vorhanden sein, die das Überschreiten der zulässigen Bereiche verhindert. Dabei ist zu berücksichtigen, daß die gewählte Strategie in die zufällige Folge der Zufallszahlen eingreift und sie damit teilweise durch eine deterministische Folge ersetzt. Die Zufälligkeit ist andererseits die Voraussetzung dafür ist, daß die mit den Taktsignalen verkoppelten Stromimpulse der angeschlossenen Verarbeitungsstufen möglichst keine hervorgehobenen Frequenzanteile als Oberwellen aufweisen. Die Strategie soll somit möglichst wenig in die Zufallszahlenfolge eingreifen. Eine Analyse der verschiedenen Strategien über geeignete Rechnersimulationen zeigt deutlich die unterschiedlichen Wirkungen und erlaubt eine Optimierung gemäß den jeweiligen Betriebsparametern. In diese gehen z.B. die Frequenz des Systemtaktes, die minimal zulässige Taktphase, der erlaubte Frequenz- oder Phasenbereich, aber auch der erforderliche Schaltungsaufwand mit ein. In vielen Fällen können vorzugebende Grenzen während des normalen Betriebsfalles auch unterschiedlich groß sein, beispielsweise während erster Zeitintervalle engere Grenzen und außerhalb dieser Zeitintervalle breitere Grenzen. Dies wirkt sich natürlich günstig auf die Verschleifung aus. Es muß jedoch durch die gewählte Strategie der Rückführung sichergestellt sein, daß spätestens mit dem Beginn der ersten Zeitintervalle die engeren Grenzen wieder erreicht werden. Aus der Strategie ergibt sich somit im Umkehrschluß, wie weit sich die Frequenz und Phase während der zweiten Zeitintervalle vom Sollwert entfernen dürfen.

Ein Verfahren zur Erzeugung einer modifizierten Zufallszahl, die in einem Taktgeber gemäß der Erfindung dem Integrator anstatt einer Zufallszahl zur Integration zugeführt ist, ist in Anspruch 10 definiert.

Die Erfindung und vorteilhafte Weiterbildungen werden nun anhand der Figuren der Zeichnung näher erläutert:
Fig. 1 zeigt als Blockschaltbild ein erfindungsgemäßes Ausführungsbeispiel des Taktgebers,
Fig. 2 und Fig. 3 zeigen an einer Taktflanke die möglichen Phasensprünge,
Fig. 4 zeigt einen Ringoszillator als Phasenmodulator,
Fig. 5 zeigt im Zeitdiagramm einige phasenverschobene Taktflanken,
Fig. 6 zeigt schematisch zwei unterschiedlich große Aufenthaltsbereiche mit Zufallszahlen,
Fig. 7 bis Fig. 12 zeigen in Diagrammform Beispiele für Aufenthaltsbereiche in Abhängigkeit von der gewählten Frequenz des Systemtaktes,
Fig. 13 zeigt einen Teil der Kontrolleinrichtung,
Fig. 14 zeigt eine zugehörige Verarbeitungstabelle,
Fig. 15 zeigt eine weitere Teilschaltung der Kontrolleinrichtung und
Fig. 16 zeigt als Blockschaltbild eine Parallelverarbeitung.

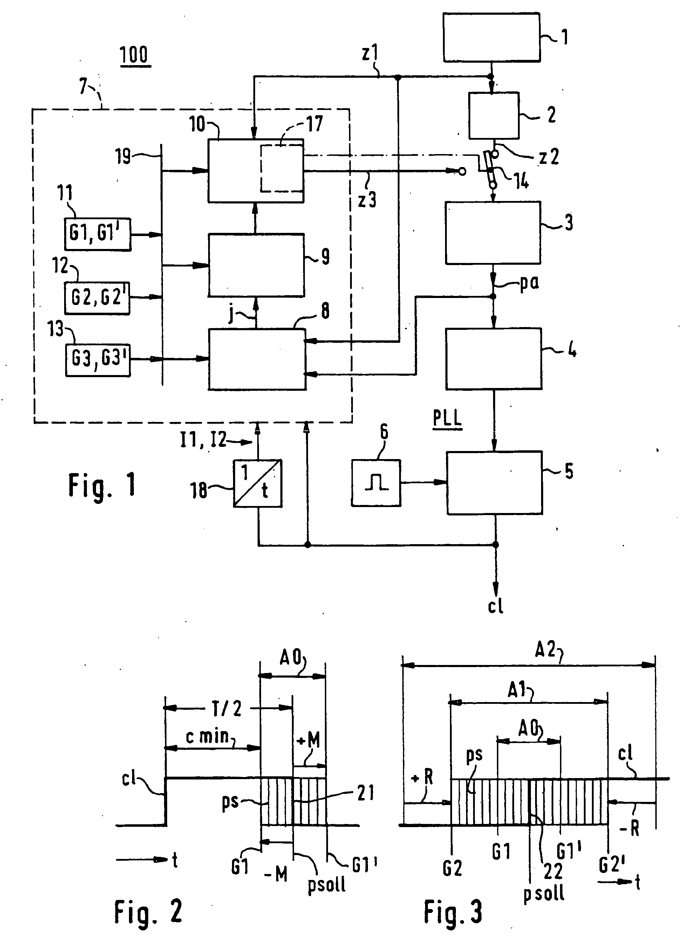

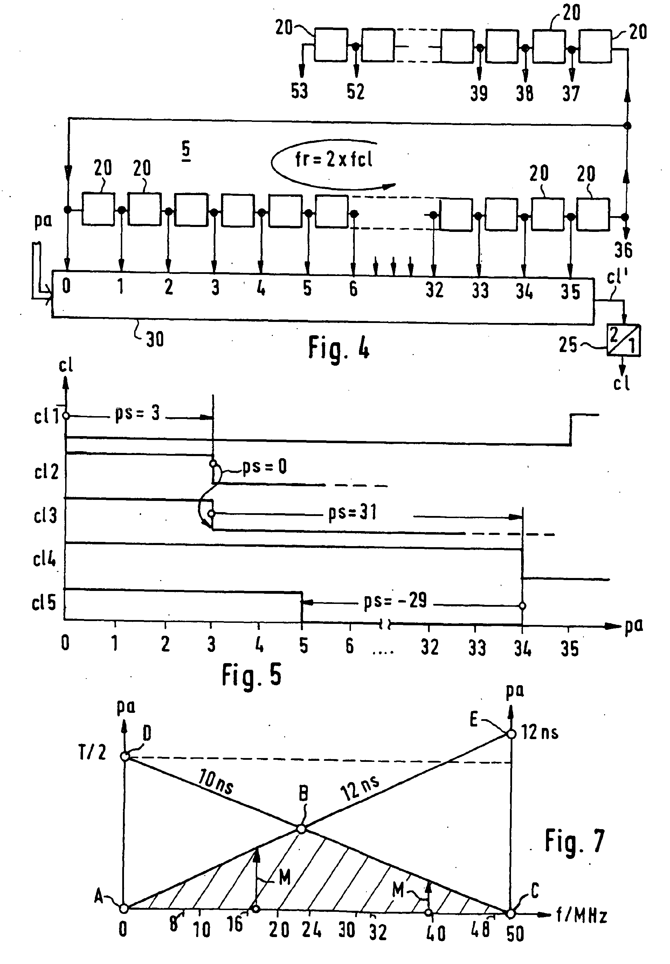

Fig. 1 zeigt schematisch als Blockschaltbild ein Ausführungsbeispiel eines Taktgebers 100 nach der Erfindung. Ein Zufallszahlgenerator 1 erzeugt Zufallszahlen z 1 und liefert diese über eine Verzögerungseinrichtung 2 an einen Integrator 3. Der Integrator 3 integriert die zugeführten Zufallszahlen z2, z3 die positiv oder positiv und negativ sein können. Mit dem Integrationswert pa der zu integrierenden Zufallszahl z1 bzw. z2 ist ein Phasenmodulator 4 gespeist, dessen Ausgang auf einen steuerbaren Oszillator 5 geführt ist, dessen jeweilige Phasenlage vom Integrationswert pa abhängig ist. Der Oszillator 5 kann Teil einer Phasenverriegelungsschleife PLL (= Phase Locked Loop) mit einem Referenzoszillator 6 und einem Ringoszillator sein, dessen Gesamtverzögerungszeit durch den Referenzoszillator 6 geregelt ist. Der Ringoszillator enthält eine Vielzahl von Abgriffen, die einzeln ansteuerbar sind und den Systemtakt cl in unterschiedlichen Phasen liefern. Die einzelnen Verzögerungszeiten entsprechen dabei nur Bruchteilen der Systemtaktperiode, beispielsweise kann ein Halbtakt durch 35 Verzögerungsstufen in 35 unterschiedlichen Taktphasen aufgeteilt werden. Der Phasenmodulator 4 und der Oszillator 5 können auch miteinander kombiniert sein wie in Fig. 4.

Der beschriebene Signalpfad zur Erzeugung des Systemtaktes cl wird durch eine Kontrolleinrichtung 7 beeinflußt, die eine Integratornachbildung 8, einen Vergleicher 9 und eine Auswahleinrichtung 10 enthält. Ferner enthält die Kontrolleinrichtung Speicher 11, 12, 13 für einen ersten, zweiten und dritten Grenzwert G1, G2, G3 und gegebenenfalls zugehörige Gegengrenzwerte G1', G2', G3', die über einen Datenbus 19 der Integratornachbildung, dem Vergleicher und der Auswahleinrichtung zuführbar sind. Die Gegengrenzwerte sind vorzugsweise die Bezugsphasenwerte pa = 0 oder die negierten Grenzwerte G1, G2, G3 und die separate Speicherung entfällt dann.

In der Integratornachbildung 8 wird geprüft, ob die neue Zufallszahl z 1 nach dem Integrationsschritt innerhalb der zweiten oder dritten Grenzwerte G2, G2', G3, G3' bleibt. Hierzu wird die Integratornachbildung mit dem aktuellen Integrationswert pa gespeist und die neue Zufallszahl z1 je nach Vorzeichen addiert oder subtrahiert. Das Integrationsergebnis j wird im Vergleicher 9 mit den Grenzwerten G2, G2', G3, G3' verglichen und das Ergebnis der Auswahleinrichtung 10 zugeführt. Diese ist mit einer Modifikationseinrichtung 17 verbunden, die gegebenenfalls eine modifizierte Zufallszahl z3 abgibt, die über einen elektronischen Schalter 14 dem Eingang des Integrators 3 anstatt der verzögerten Zufallszahl z2 zugeführt ist. Die Auswahleinrichtung 10 enthält die logischen Operationen, um zu entscheiden, ob die Zufallszahl z1 integriert werden soll oder in welcher Weise die Modifikation stattzufinden hat, damit die entsprechenden Grenzwerte eingehalten werden.

Fig. 2 zeigt am Beispiel einer abfallenden Taktflanke 21 eines Systemstaktes cl, wie diese Taktflanke in positiver oder negativer Zeitrichtung durch die einzelnen Phasenschritte ps verändert werden kann. Die minimal zulässige Taktphase cmin, die einem unteren Grenzwert, der erste Grenzwert G1, entspricht, darf dabei nicht unterschritten werden, weil ansonsten die Signalverarbeitungszeit in den angeschlossenen Schaltungsblöcken zu gering wird. Von der Solltaktperiode oder Sollphase pso11 ausgehend ergibt sich somit ein die aktive Taktphase verkleinernder Maximalsprung, -M, der keinesfalls überschritten werden darf. Der die aktive Taktphase vergrößernde Phasensprung ist dieser Beschränkung eigentlich nicht unterworfen. Aus Zweckmäßigkeitsgründen begrenzt man jedoch auch den positiven Phasensprung auf den gleichen Betrag M. Fig. 2 zeigt hierzu den Maximalsprung +M und der zugehörige obere Grenzwert ist G1'. Durch die Grenzen G1, G1' wird ein Aufenthaltsbereich A0 definiert, der dem zulässigen Aufenthaltsbereich bei einer reinen Phasenmodulation, also ohne Integrator 3, entspricht. Wenn der Phasensprung nicht von der Sollphase ausgeht, kann der Maximalsprung bis zur Bereichsgrenze G1, G1' entsprechend größer oder kleiner sein. Im Grenzfall geht der Maximalsprung von der einen Bereichsgrenze bis zur anderen.

In Fig. 3 ist schematisch der Aufenthaltsbereich einer Anstiegsflanke 22 in einem ersten oder zweiten Zeitintervall I1, I2 dargestellt. Dieser Fall ist dann von Interesse, wenn die Flanke zeitweilig weiter als in Fig. 2 von der Sollphase pso11 wegwandern kann, ohne die Forderung nach der minimalen Taktphase cmin zu verletzen. Dies ist erfüllt, wenn die einzelnen Phasenschritte ps dabei die zulässigen Maximalsprünge M, -M, beispielsweise von Fig. 2, nicht überschreiten. Die Grenzwerte für diesen Aufenthaltsbereich A1 sind durch G2, G2' dargestellt, wobei der Bereich sich zweckmäßigerweise symmetrisch um die Sollphase pso11 erstreckt. In der Regel sollte dieser Aufenthaltsbereich A1 größer als der Aufenthaltsbereich A0 sein. Bei geringen Taktfrequenzen gilt dies nicht, vergl. in Fig. 7 den Frequenzbereich unterhalb von 24 MHz.

Wenn in dem zweiten Zeitbereich I2 ein noch größerer Aufenthaltsbereich A2 zulässig ist, dann muß durch eine entsprechende Rückführungsstrategie +R, -R, sichergestellt sein, daß spätestens zu Beginn des ersten Zeitintervalls I1 wieder deren Bereichsgrenzen G, G2' erreicht werden. Zweckmäßige Rückführstrategien R zur Einhaltung der Aufenthaltsbereiche A0, A1, A2 werden später ausführlich erläutert.

In Fig. 4 ist schematisch ein Ausführungsbeispiel für einen in der Phase steuerbaren Oszillator 5 dargestellt, der als Ringoszillator ausgebildet ist. Der Ringoszillator enthält in seiner Ringschaltung 35 hintereinander geschaltete Verzögerungsstufen 20, deren gesamte Verzögerungszeit zusammen auf die halbe Periodendauer T/2 des Systemtaktes cl mittels der nicht näher dargestellten Phasenregelungsschleife PLL geregelt ist. Die Abgriffe an den einzelnen Verzögerungsstufen sind mit einem Vielfachschalter 30 verbunden, der je nach dem zugehörigen Integrationswert pa, der den akkumulierten Phasenwert darstellt, einen dieser Anschlüsse auswählt und als Hilfstakt c1', der die doppelte Frequenz des Systemtaktes cl hat, einem Frequenzteiler 25 zuführt. Am Ausgang dieses Frequenzteilers ist der Systemtakt cl abgreifbar, der mittels einer nicht dargestellten Treiberstufe verstärkt wird. Duch den Hilfstakt wird die Anstiegs- und Abstiegsflanke des Systemtaktes voneinander unabhängig in der Phase modifiziert.

Die in Fig. 4 dargestellte Anordnung ist dann von Vorteil, wenn die Sollphase beim Null-Bezugsphasenwert pa = 0 liegt und die einzelnen Verzögerungsschritte ps demgegenüber den Hilfstakt c1' verzögern. Wenn dagegen positive und negative Phasenschritte +ps, -ps vorgesehen sind, dann ist es sinnvoller, die Bezugsphase nicht mit dem Anfang der Verzögerungskette zu verbinden, sondern mit einem späteren Abgriff. Damit der Bereich der zulässigen positiven und negativen Phasenschritte dabei nicht eingeschränkt wird, ist es ferner zweckmäßig an das Ende 36 der Verzögerungskette eine weitere, nicht zu kurze Verzögerungskette hier mit den Abgriffen 37 bis 53 anzuschließen, die aber nicht innerhalb des geschlossenen Rings liegt, jedoch für jeden Verzögerungsabgriff einen zugehörigen, in Fig. 4 nicht dargestellten Eingang beim Vielfachschalter 30 erfordert. Die angehängte Verzögerungskette mit den Verzögerungsgriffen 37 bis 53 vermeidet die Umrechnung der ursprünglichen Abgriffe 0 bis 35 beim Auftreten von Phasenschritten, die größer oder kleiner als dieser Bereich sind.

In Fig. 5 sind in einem Zeitdiagramm einige phasenverschobene Taktflanken dargestellt. Die abfallende Taktflanke des ersten Taktes cl1 beginnt bei der Bezugsphase 0, die dem akkumulierten Phasenwert pa = 0 entspricht und die ansteigende Flanke beim akkumulierten Phasenwert pa = 35, weil die Halbtaktperiode T/2 auf 35 Verzögerungsstufen 20 aufgeteilt ist.

Für den zweiten Takt c12 sind zur Phasenverschiebung drei Phaseninkremente ps=3 vorgesehen, so daß die abfallende Flanke beim akkumulierten Phasenwert pa=3 liegt. Der nächste Phasenschritt hat den Wert ps=0, wodurch für den dritten Takt c13 die akkumulierte Phase pa bei 3 sich nicht ändert. Der nächste Phasenschritt ps=31 verschiebt die akkumulierte Phase des vierten Taktes c14 auf den Phasenwert pa=34. Der nächste Phasenschritt ist negativ mit ps=-29 und schiebt die Phase des fünften Taktes c15 auf den akkumulierten Phasenwert pa=5.

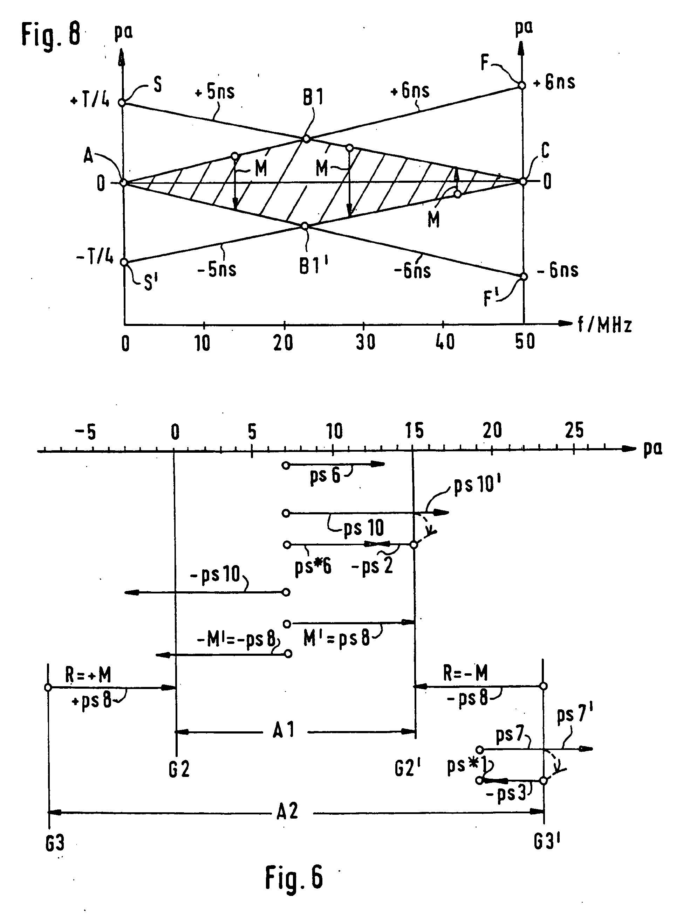

Bei der Betrachtung des Zeitdiagrammes in Fig. 5 treten Bereichsgrenzen noch nicht auf. Den Zusammenhang von Phasenschritten mit Bereichsgrenzen zeigt Fig. 6. Der zweite Grenzwert G2 mit zugehörigem Gegenwert G2' bildet einen ersten Aufenthaltsbereich A1 und der dritte Grenzwert G3 mit Gegenwert G3' bildet einen erweiterten Aufenthaltsbereich A2. Eine Skalierung zeigt die akkumulierten Phasenwerte pa. Der Skalierungsumfang erstreckt sich unsymmetrisch von -8 bis 23. Der erste Phasenschritt ps6, der über sechs Phaseninkremente geht und vom Phasenwert pa=7 startet, liegt voll innerhalb des ersten Aufenthaltsbereiches A1. Der vom gleichen Phasenwert gestartete Phasenschritt ps10 käme jedoch auf den Phasenwert 17, der außerhalb des ersten Bereiches A1 liegt. Zur Einhaltung der Bereichsgrenze G2' wird bei diesem Phasenschritt ein sogenanntes Spiegelungsverfahren durchgeführt, bei dem der über die Bereichsgrenze G2' hinausgehende Phasenschritt ps10' gespiegelt wird und einem von der Bereichsgrenze G2' ausgehenden negativen Phasenschritt -ps2 entspricht. Anstatt des Phasenwertes 17 erzeugt der gespiegelte Phasenschritt ps10 den Phasenwert 13. Dies entspricht insgesamt einem resultierenden Phasenschritt ps*6 von 6 Phaseneinheiten.

Bei diesem Verfahren können relativ große Phasenschritte ps zugelassen werden, es ist jedoch ein gewisser Rechenaufwand erforderlich. Der größtmögliche resultierende Phasenschritt bei Spiegelung geht von Bereichsgrenze G2 zu Bereichsgrenze G2' oder umgekehrt, sofern der zulässige Maximalsprung M, der sich aus der cmin-Forderung ergibt, dabei nicht überschritten wird.

Vom Phasenwert 7 ausgehend überschreitet der negative Phasenschritt -ps10 den unteren Grenzwert G2, der beim Phasenwert 0 liegt. Soll ohne Spiegelung erreicht werden, daß alle Phasenschritte ps innerhalb der Bereichsgrenzen G2, G2' liegen, dann wird dadurch ebenfalls ein Maximalsprung M definiert, der im angenommenen Beispiel von Fig. 6 den Phasenschritt ps=8 aufweist. Dies ist nämlich der größte Phasenschritt, der vom mittleren Phasenwert oder Phasenpaar (pa=7, pa=8) ausgehend höchstens eine der beiden Bereichsgrenzen G2, G2' überschreitet aber innerhalb der anderen Bereichsgrenze G2' G2 bleibt. Die genaue Maximalsprungweite M' entspricht der aufgerundeten Hälfte des ersten Bereiches A1. Daß der von pa = 7 ausgehende negative Maximalsprung -M' außerhalb der unteren Bereichsgrenze G2 landet, ist unwesentlich, wenn für den letztlich zu integrierenden Maximalsprung M' das Vorzeichen +/- durch die Modifikationseinrichtung 17 in richtiger Weise vorgegeben wird. Dieser von der Bereichsmitte ausgehende Maximalsprung M' ist etwa halb so groß wie der bei der Spiegelung mögliche resultierende Maximalsprung M*. Im folgenden wird vereinfachend als Maximalsprung nur "M" angegeben, um die jeweilige Strategie (Spiegelung oder Richtungsumkehr) zur Definition des Maximalsprunges nicht einzuschränken. Gegebenenfalls ist aus den Darstellungen ersichtlich, welcher Maximalsprung M*, M' gemeint ist.

Der erweiterte Aufenthaltsbereich A2 mit den Grenzen G3, G3' ist in Fig. 6 durch eine spezielle Rückkehrstrategie R bestimmt, bei der beispielsweise mittels eines einzigen Maximalsprungs M - also M* oder M' - der erste Bereich A1 wieder erreichbar sein muß. Zur Einhaltung der Grenzen G3, G3' gibt es ebenfalls wieder verschiedene Möglichkeiten, wobei der dargestellte Phasenschritt ps7 wieder als Beispiel für das Spiegelungsverfahren dient. Im folgenden werden einige Rückführungsstrategien kurz aufgelistet, die für den ersten oder zweiten Bereich A1, A2 aber zum Teil auch für den Bereich A0 anwendbar sind:
1. Ersatz mindestens einer zu integrierenden Zufallszahl durch einen vorgegebenen Phasensprung, insbesondere den Maximalsprung M, oder durch eine vorgegebene Folge von Phasensprüngen;
2. Ersatz mindestens einer zu integrierenden Zufallszahl durch Spiegelung des Überschußwertes an der jeweiligen Bereichsgrenze;
3. Ersatz mindestens einer zu integrierenden Zufallszahl durch eine Richtungsänderung mittels einer Vorzeicheninvertierung;
4. Ersatz mindestens einer zu integrierenden Zufallszahl, die über den Bereich der dritten Grenzwerte G3, G3' hinausführt, durch einen Ersatzwert, der die Rückkehr in den Bereich der zweiten Grenzwerte G2, G2' zu einem vorgegebenem Zeitpunkt garantiert;
5. Wiederholung der letzten Zufallszahlenfolge oder zeitliche umgekehrte Wiederholung der letzten Zufallszahlenfolge oder eine Wiederholung der letzten Zufallszahlenfolge in zeitlich zufälliger Reihenfolge, evtl. unter Umkehrung der Vorzeichen;
6. Unterdrückung der jeweils gebildeten Zufallszahl bis eine passende Zufallszahl erscheint und
7. Kombinationen obiger Rückführstrategien, z.B. Nr. 1 und Nr. 3.

In den Fig. 7 bis Fig. 12 sind in Diagrammform Beispiele für Aufenthaltsbereiche der akkumulierten Phasen pa in Abhängigkeit von der gewählten Frequenz des Systemtaktes cl dargestellt. In horizontaler Richtung ist die Frequenzachse aufgetragen mit den Frequenzen von 0 bis 50 MHz. In vertikaler Richtung ist auf der linken Seite ein Halbtakt T/2 aufgetragen, dem die Verzögerungszeiten sämtlicher im Ring geschalteter Verzögerungsstufen 20 entsprechen, beispielsweise 35 Verzögerungsstufen wie in Fig. 4. Entsprechend der Projektion auf diesen Pfeil wird also die jeweilige Anzahl von Verzögerungsstufen 20 definiert. Die von D nach C laufende Linie 10 ns gilt für den angenommenen Fall, daß die jeweilige Taktphase mindestens 10 ns groß sein muß. Der vertikale Pfeil auf der rechten Seite ist ebenfalls mit der Halbtaktperiode T/2 skaliert, aufgetragen wird jedoch in vertikaler Richtung der maximal zulässige Phasenwert des ersten Bereiches A1. Die von A nach E gehende Linie beschreibt daher den akkumulierten Phasenwert pa, der nicht überschritten werden darf um den als Beispiel vorgegebenen 12 ns-Bereich nicht zu verletzen. Im Gegensatz dazu beschreibt die von D nach C laufende Linie die Grenze für die akkumulierten Phasenwerte, die aufgrund des 10 ns-Mindestphasenbereichs nicht überschritten werden dürfen. Die möglichen Maximalsprünge M sind daher einmal durch die Verbindungslinie A, B und zum anderen durch die Verbindungslinie B, C definiert. Das Dreieck A, B, C gibt bei reiner Phasenmodulation den Aufenthaltsbereich für die Phasenwerte unter den gegebenen Bedingungen, also 10ns-Mindestphase und 12ns-Phasenaufenthaltsbereich, an. Alle Phasenwerte können direkt vom Zufallszahlengenerator erzeugt werden.

Die Verbindungslinie DC von Fig. 7 zeigt, daß bei dem dargestellten Beispiel bei einer niedrigen Taktfrequenz von 4 MHz die Forderung nach einer ausreichend langen und aktiven Taktphase, deren Grenze durch cmin definiert ist, nahezu während des gesamten Halbtaktes T/2 eingehalten wird. Der Vollständigkeit halber wird darauf hingewiesen, daß der Bereich von T/2 bis T der inaktive Bereich der Taktphase ist, bei dem das Taktsignal um 180 Grad in der Phase gedreht ist. Im Gegensatz hierzu ist bei einer beispielsweise hohen Taktfrequenz von 48 MHz der Halbtakt T/2 sehr kurz, nämlich nur 10,4 ns lang. Hier würde mit einem negativen Phasensprung von -0,4 ns bereits der Grenzwert cmin = 10 ns erreicht werden. Das wäre bei einer zwischen 0,21 ns und 0,39 ns liegenden kleinsten Phasenschrittweite gerade noch ein Phasenschritt. Werden in einem angenommenen Beispiel zwanzig Verzögerungsstufen pro Halbtakt T/2 verwendet, dann hat die kleinste Phasenschrittweite bereits einen Wert von 0,52 ns. Mit diesem Wert wäre die Bedingung cmin = 10ns nicht mehr einzuhalten. Die Taktphase könnte in diesem Fall nicht mehr variiert werden und wäre fest. Um die gewünschte Phasenvariation des Taktes zu realisieren müßte bei dieser Taktfrequenz die Anzahl der Verzögerungsstufen deutlich erhöht werden.

Die Verbindungslinie AE von Fig. 7 zeigt, daß bei einer beispielsweise niedrigen Taktfrequenz von 4 MHz die Forderung innerhalb des Aufenthaltsbereiches mit 12 ns zu bleiben, nur schwer einzuhalten ist, weil infolge der geringen Taktfrequenz, die einzelnen Phasenschritte gegenüber dem Aufenthaltsbereich von 12 ns relativ groß werden. Bei der bereits erwähnten Verzögerungskette von 20 Stufen auf T/2 entspricht jede Verzögerungsstufe einem Phasenschritt von etwa 6,2 ns. Der angenommene Aufenthaltsbereich von 12 ns läßt somit nur noch einen einzigen Phasenschritt ohne Grenzwertüberschreitung zu. Auch in diesem Fall ist eine deutliche Erhöhung der Anzahl von Verzögerungsstufen erforderlich, um die Stufung der Phasenschritte zu verkleinern und damit eine Variation der Taktphase zu ermöglichen.

Bei einer beispielsweise hohen Frequenz von 48 MHz ist die Einhaltung des 12 ns-Aufenthaltsbereiches unkritisch, weil die Stufung der Phasenschritte gegenüber 12 ns fein ist, nämlich etwa 0,52 ns bei 20 Verzögerungsstufen auf T/2, entsprechend dem angenommenen Beispiel.

Der resultierende Aufenthaltsbereich A, B, C ergibt sich aus den vorausgehenden Überlegungen, wobei die Grenzen durch die jeweils ungünstigeren Bedingungen bestimmt werden. Der günstigste Bereich für die Wahl der Taktfrequenz und der Anzahl der Verzögerungsstufen läßt sich aus einem derartigen Diagramm leicht ermitteln. Für die angenommenen Parameter des Diagramms von Fig. 7 liegt er etwa im mittleren Frequenzbereich bei 24 MHz, weil dort der maximal zulässige Phasensprung M am größten ist, und damit auch die größte Phasenvariation erlaubt.

Im Diagramm von Fig. 7 und den folgenden Diagrammen ist der maximale Phasensprung M durch den für die jeweilige Taktfrequenz und eine reine Phasenmodulation gültigen Abstand der Bereichsgrenzen entsprechend Fig. 7 und Fig. 8 definiert. Der dort von Bereichsgrenze zu Bereichsgrenze reichende Phasensprung verwendet dabei als Rückkehrstrategie die bereits erläuterte Spiegelung an der Bereichsgrenze. Die maximal mögliche Sprungweite reicht somit von der einen Bereichsgrenze zur anderen.

Fig. 8 zeigt den Aufenthaltsbereich wieder bei einer reinen Phasenmodulation, also ohne Integrator, wobei aber der Aufenthaltsbereich für die zulässigen Phasen symmetrisch um den Bezugsphasenwert 0 liegen soll. Der Aufenthaltsbereich von 12 ns teilt sich so auf den Bereich von -6ns bei F' bis +6ns bei F auf. Die Größe der Maximalsprünge M bei Spiegelung hat sich nicht geändert. Die Sprünge erfolgen jedoch über die Null-Bezugsphase. Der durch die Raute A, B1', C, B 1 gebildete Aufenthaltsbereich für eine reine Phasenmodulation hat die gleiche Größe wie der Bereich A, C, B von Fig. 7. Da die 10ns-Grenze sich ebenfalls gleichmäßig auf beiden Seiten der jeweiligen Taktflanke erstreckt, beginnen die zugehörigen Grenzkurven (S,C bzw. S'C) bei T/4 bzw. -T/4.

Der Phasenaufenthaltsbereich nach Fig. 7 und Fig. 8 entspricht einem Taktgeber ohne Integrator. Die Darstellung dient der Erläuterung bestimmter Grundbegriffe, die bei den folgenden Diagrammen ebenfalls verwendet werden.

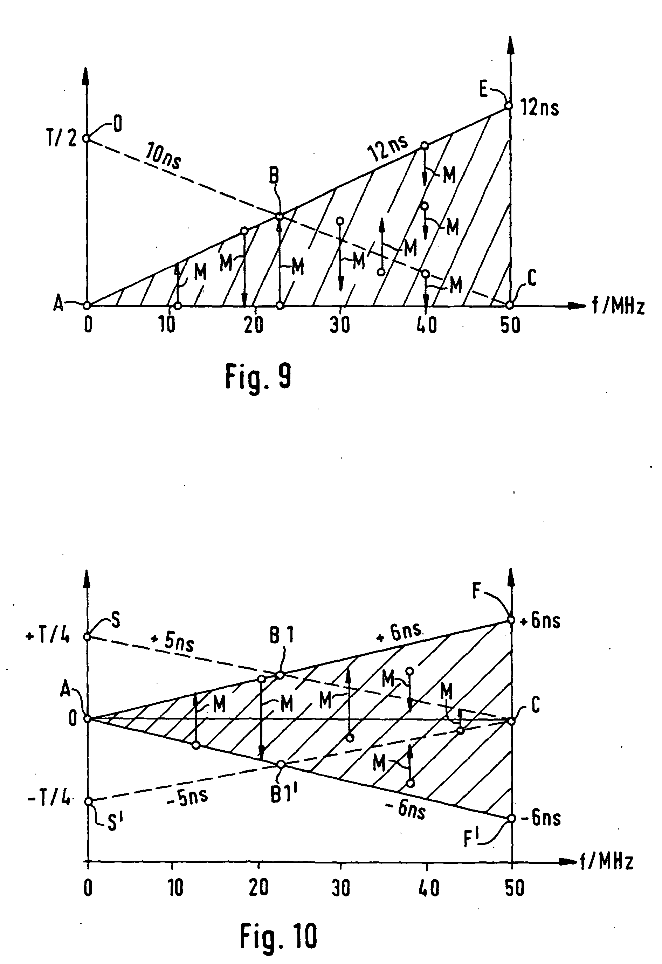

Fig. 9 zeigt das Aufenthaltsdiagramm bei einem Taktgeber mit einem Integrator nach der Erfindung unter den gleichen Anforderungen an den Systemtakt wie bei den Figuren 7 und 8. In Fig. 9 ist der unsymmetrische Fall gezeigt, der vom Phasenbezugswert 0 ausgeht und positive Phasenabweichungen aufweist. Der gestrichelte Aufenthaltsbereich A, C, E ist gegenüber Fig. 7 um die Fläche B, C, E größer geworden. Die Bedingungen für den Maximalsprung M sind durch die Verbindungslinien A, B und B, C gegeben. Die eingezeichneten Pfeile entsprechen alle den für die jeweilige Frequenz zugeordneten Maximalsprüngen. Bei 40 MHz zeigen drei übereinander liegende Maximalsprünge M, daß der Aufenthaltsbereich dort deutlich größer als der bei dieser Frequenz zulässige Maximalsprung M ist. Der durch die Frequenzmodulation entstandeneAufenthaltsbereich A1 ist hier größer als der durch den zulässigen Maximalsprung M definierte Aufenthaltsbereich A0

Das Diagramm von Fig. 10 unterscheidet sich gegenüber dem Diagramm von Fig. 9 lediglich dadurch, daß die Bereichsgrenzen symmetrisch um den Phasenbezugswert 0 angenommen sind. Bei tiefen Frequenzen sind die Maximalsprünge durch die von A bis B 1 und A bis B1' verlaufenden 6ns-Grenzlinien begrenzt. Der größte Maximalsprung M wird bei B1, B1' erreicht und ist gleich groß wie der Maximalsprung bei B in Fig. 9. Die beiden 5 ns-Grenzlinien verlaufen wie in Fig. 8 von S nach C und S'nach C; die Schnittpunkte mit den Linien AF bzw. Af' sind B 1 und B1'. Die Aufenthaltsfläche A, F', F ist identisch zur Aufenthaltsfläche A, C, E von Fig. 9.

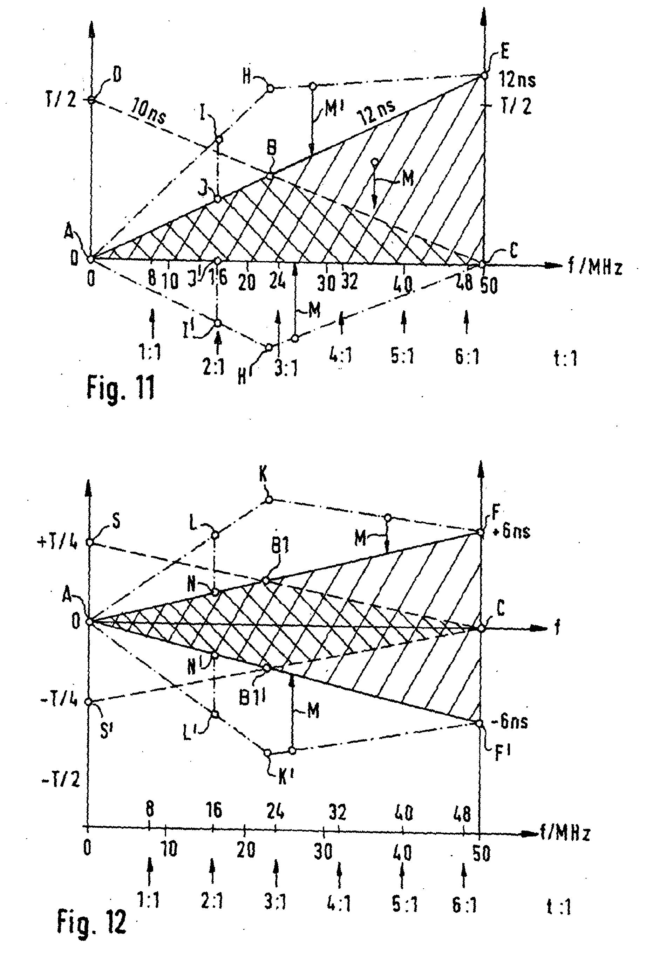

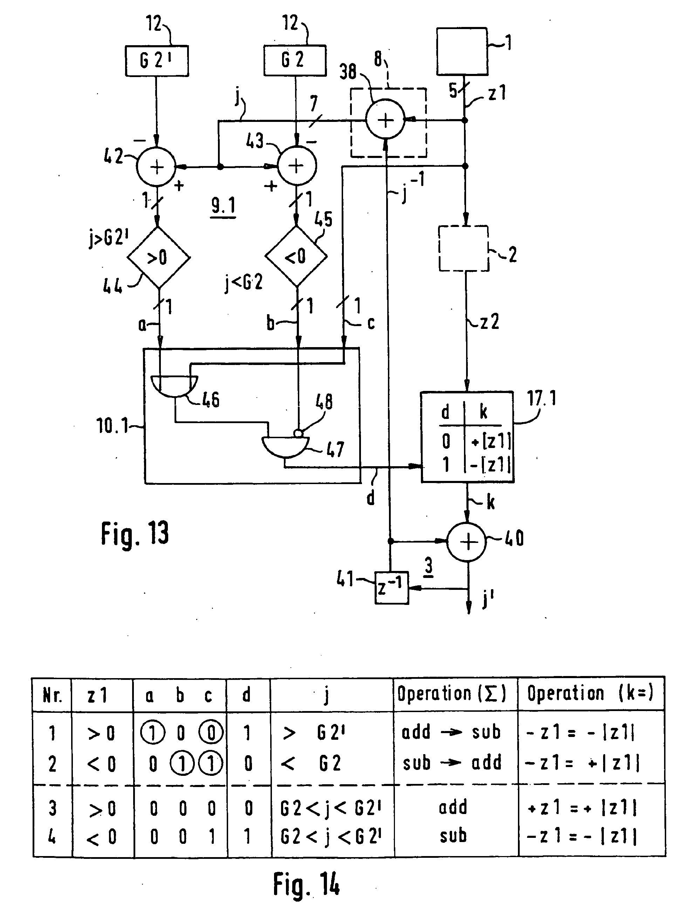

Die Diagramme der Fig. 11 und 12 sind teilweise zu den Diagrammen der Fig. 9 bzw. 10 gleich und enthalten insbesondere deren Aufenthaltsbereiche A, C, E bzw. A, F', F. Zusätzlich enthalten diese Diagramme aber einen ergänzenden Aufenthaltsbereich E, H, I, J und C, H', I', J' bzw. F, K, L, N und F', K', L', N'. Diese Aufenthaltsbereiche ergeben sich dadurch, daß gemäß Fig. 3 oder Fig. 6 mindestens für vorgesehene Zeitintervalle I2 ein erweiterter Aufenthaltsbereich A2 gilt. Mittels eines einzigen Maximalsprungs M sind jedoch die Grenzen der 12 ns- Aufenthaltsbereiche A1 A, C, E bzw. A, F, F' wieder erreichbar. Die zugehörigen Zeitintervalle I2 bestimmen sich beispielsweise aus dem Frequenzteiler 18 von Fig. 1. Ausgehend von einem relativ hochfrequenten Systemtakt cl werden beispielsweise Daten mit einer wesentlich niedrigeren Taktrate über einen externen Bus abgefragt, für den die relativ engen Phasengrenzen 12 ns erforderlich sind. Außerhalb dieser speziellen Datenübernahme können die Phasen jedoch weiter weglaufen, was den Zusatzbereichen in Fig. 11 und Fig. 12 entspricht.

Die Grenzen I, J; I', J' bzw. L, N; L', N'hängen mit dem Teilungverhältnis des Teilers 18 zusammen, das in Fig. 11 und 12 als t: angegeben ist. Wenn der Teiler 18 gar nicht vorhanden ist, dann ist das Teilungsverhältnis 1:1 und in jedem Systemtakt cl muß die engere Aufenthaltsbedingung A1 eingehalten werden. Erst bei einem Teilungsverhältnis 2:1 ist ein erweiterter Aufenthaltsbereich A2 für jeden zweiten Takt möglich. Der erste Takt hat einen engen Aufenthaltsbereich A1, der nächste einen weiten A2, der dritte wieder einen engen A1 usw.. Wenn beispielsweise für die Abfrage des engen Aufenthaltsbereiches A1 eine feste Frequenz von 8 MHz vorgegeben wird, dann kann der Teiler 18 entsprechend den von 0 bis 50 MHz gehenden Diagrammen höchstens das Teilungsverhältnis 6:1 aufweisen. Der Systemtakt cl hat dann höchstens die Frequenz 48 MHz und der maximale Phasenschritt M beträgt bei 20 Verzögerungsstufen nur noch einen einzigen Phasenschritt. Der Phasenaufenthaltsbereich reicht indessen in Fig. 11 von C bis nahezu E oder in Fig. 12 nahezu von F' bis F. Die Realisierung des negativen Phasenbereiches C, H', I', J' bezüglich der Bezugsphase pa = 0 erfordert eine entsprechende Ausbildung der Verzögerungseinrichtung oder dieser negative Phasenbereich muß entfallen. Wenn die Bezugsphase pa = 0 jedoch im mittleren Bereich der Verzögerungskette liegt, dann sind die negativen Phasen leicht realisierbar. Das Diagramm hierzu zeigt Fig. 12.

Das Blockschaltbild von Fig. 13 zeigt als Teilschaltung der Kontrolleinrichtung 7 ein Schaltungsbeispiel zur Vorzeichenumkehr bei einer Bereichsüberschreitung. Hierzu wird die vom Zufallszahlengenerator 1 gebildete Zufallszahl z1 einer Integratornachbildung 8 zugeführt, die einen Addierer/Subtrahierer als Recheneinheit 38 enthält. Je nach dem Vorzeichen der Zufallszahl z1 bildet die Recheneinheit 38 die Summe oder Differenz aus dem alten Integrationswert j⁻¹ und der neuen Zufallszahl z1. Das Ergebnis dieses Rechenvorgangs ist ein Testintegrationswert j, der dem Addiereingang einer ersten und zweiten Recheneinheit 42, 43 im Vergleicher 9.1 zugeführt ist. Diesen beiden als Addierer oder Subtrahierer dienenden Recheneinheiten 42, 43 ist am jeweiligen Subtrahiereingang der aus dem Speicher 12 ausgelesene Grenzwert G2' bzw. G2 zugeführt, dessen jeweiliger Wert vorzeichenrichtig vom Testintegrationswert j subtrahiert wird. Bei einer Überschreitung der Grenze G2', also wenn j > G2' ist, liefert die erste Recheneinheit 42 einen Ausgangswert, der größer als 0 ist. Bei einer Unterschreitung der Grenze G2, also wenn j < G2 ist, liefert die zweite Recheneinheit 43 einen Ausgangswert, der kleiner als 0 ist. Bei der Verwendung von Zweierkomplementzahlen für die Zufallszahlen z1 und deren weiteren Verarbeitung gibt die MSB-Stelle (MSB= most significant bit) das jeweilige Vorzeichen an - "0" ist positiv und "1" ist negativ. Von den Ausgangswerten der Recheneinheiten 42, 43 muß somit lediglich die MSB-Stelle in einem ersten bzw. zweitem Bewerter 44, 45 geprüft werden. Die Bewertung liefert ein erstes und zweites Logiksignal a, b, das zusammen mit einem dritten Logiksignal c, das dem Vorzeichen oder der MSB-Stelle der Zufallszahl z1 entspricht, einer Auswahleinrichtung 10.1 zugeführt ist. Diese verknüpft die drei Logiksignale A, B, C mit einer Kombination aus einem ODER-Tor 46 und einem UND-Tor 47, wobei letzteres einen negativen Eingang 48 für das Logiksignal b aufweist. Das Ergebnis dieser logischen Verknüpfung ist ein viertes Logiksignal d, das einer ersten Teilschaltung 17.1 der Modifikationseinrichtung 17 als Steuersignal zugeführt ist. Die Teilschaltung 17.1 liefert in Abhängigkeit vom Logiksignal d an ihrem Ausgang als Ausgangswert k die ursprüngliche Zufallszahl z1 bzw. die durch die Verzögerungseinrichtung 2 verzögerte Zufallszahlen z2 oder eine andere Zahl, beispielsweise eine modifizierte Zufallszahl z1.

Die in der ersten Teilschaltung 17.1 dargestellte Tabelle gibt an, wie der Ausgangswert k mit der ursprünglichen Zufallszahl z1 und dem Steuersignal d zusammenhängt. Wenn das Signal d den Logikzustand 0 hat, dann ist die Ausgangszahl k eine positive Zahl, unabhängig vom Vorzeichen der ursprünglichen Zufallszahl z1. Wenn das Signal d den Logikzustand 1 hat, dann ist die Ausgangszahl k eine negative Zahl, unabhängig vom ursprünglichen Vorzeichen der Zufallszahl z1. Der Zusammenhang zwischen dem Logiksignal d und der Bearbeitung der ursprünglichen Zufallszahl z1 wird in der nachfolgenden Tabelle von Fig. 14 ausführlich dargestellt. Mit der von der Modifikations-Teilschaltung 17.1 abgegebenen Zahl k wird sichergestellt, daß bei der Integration dieser Zahl k im Integrator 3 die Grenzen G2', G2 nicht überschritten werden. Entsprechend dem Vorzeichen von k wird der Betrag von k zum bisherigen Integrationswert j⁻¹ addiert oder von ihm subtrahiert und bildet damit den neuen Integrationswert j', der am Ausgang der Akkumulator-Recheneinheit 40 zur Verfügung steht. Dieser neue Integrationswert ist einem Akkumulator-Speicher 41 zugeführt. In der nächsten Vergleichsphase dient er dann als alter Integrationswert j⁻¹.

An einigen Datenleitungen ist der erforderliche Stellenumfang neben einem kleinen Schrägstrich an der Datenleitung angegeben. Die Zufallszahl z1 weist beispielsweise fünf Stellen auf, der Ausgang der Integratornachbildung 8 sieben Stellen und die Ausgänge der Recheneinheiten 42, 43 und der Bewerter 44, 45 je eine Stelle.

In Fig. 14 ist in Tabellenform die Funktion der ersten Modifikations-Teilschaltung 17.1 der von Fig.13 dargestellt. In den einzelnen Spalten 1 bis 7 sind nacheinander angeordnet:
1. die Zeilennummer "Nr." der Tabelle,
2. die zu integrierende Zufallszahl "z1",
3. das erste, zweite und dritte Logiksignal "a", "b" und "c",
4. das resultierende Logiksignal "d",
5. der in der Integratornachbildung 8 gebildete Integrationswert "j",
6. die Angabe der durchzuführenden Operation im Integrator 3, also ob der Betrag der Zufallszahl z1 letztendlich zu addieren oder zu subtrahieren ist und schließlich
7. die mathematische Darstellung der Rechenoperation, die mit der Zufallszahl z1 durchzuführen ist, um die gewünschte Zahl k für die Integration zu erhalten.

In den Zeilen 1 und 2 verläßt der Testintegrationswert j den durch die Grenzwerte G2, G2' vorgegebene Bereich. In den Zeilen 3 und 4 bleibt der Testintegrationswert j hingegen innerhalb der vorgegebenen Grenzen G2 und G2'. Somit ändern sich in den Zeilen 3 und 4 die im Integrator 3 vorzunehmenden Rechenoperation nicht. Die ursprünglichen Rechenoperationen ergeben sich aus dem Vorzeichen der Zufallszahl z1, siehe das entsprechende Logiksignal c in Spalte 2. Aus Zeile 3 ergibt sich somit, daß die positive Zahl z1 zum bisherigen Integrationswert j⁻¹ addiert werden kann und aus Zeile 4 ergibt sich, daß die negative Zahl z1 vom bisherigen Integrationswert j⁻¹ subtrahiert werden kann.

In den Zeilen 1 und 2 verläßt der Testintegrationswert j jedoch den durch die Grenzwerte G2, G2' vorgegebene Bereich. In Zeile 1 nimmt das Signal a daher den logischen Zustand "1" an. In Zeile 2 nimmt entsprechend das Signal b den logischen Zustand "1" an. Über eine logische Verknüpfung dieser Signale a, b mit dem dritten, vom Vorzeichen der Zufallszahl z1 abhängigen Signal c, wird mittels der in Figur 13 dargestellten Torschaltungen 46, 47 das vierte Logiksignal b gebildet. Wenn die Grenzen G2, G2' unter- oder überschritten werden, dann muß das Vorzeichen der Zufallszahl z1 für die Integration geändert werden, was Spalte sechs zeigt.

Eine Änderung des Vorzeichens von z1 in Zeile eins bzw. in Zeile 2 bedeutet einen negativen bzw. positiven Zahlenwert k und eine Beibehaltung des Vorzeichens von z1 in Zeile drei bzw. vier bedeutet einen positiven bzw. negativen Zahlenwert k. Das gewünschte Vorzeichen des Zahlenwertes k von Spalte 7 ist direkt mit dem Logikzustand des Signals d von Spalte 4 korreliert, wobei der Betrag von k dem Betrag der Zufallszahl z1 gleich ist.

In der Teilschaltung 17.1 muß also in dem jeweiligen Zahlensystem entsprechend der Tabelle von Fig. 14 die Zufallszahl z1 in positiver und negativer Form bereitgestellt werden. Dies kann je nach dem verwendeten Zahlensystem durch eine Invertierung, Komplementierung, eine entsprechende Tabelle oder ein sonstiges Verfahren erfolgen. Mittels des Logiksignals d wird dann die positive oder gleich große negative Zufallszahl als Ausgangswert k ausgelesen und dem Integrator 3 zugeführt.

Das Ausführungsbeispiel von Fig. 13 und der zugehörigen Tabelle in Fig. 14 schließt andere Verfahren zur Prüfung und Modifikation der Zufallszahl z1 selbstverständlich nicht aus. Das dargestellte Beispiel verdeutlicht aber auf einfache Weise die Funktion eines Vergleichers 9.1 und einer Teilschaltung 17.1 der Modifikationseinrichtung 17. Die Strategie zur Einhaltung der vorgegebenen Grenzen über die Richtungsumkehr der Zufallszahl z1 ist zudem gegenüber anderen Verfahren sehr einfach zu realisieren.

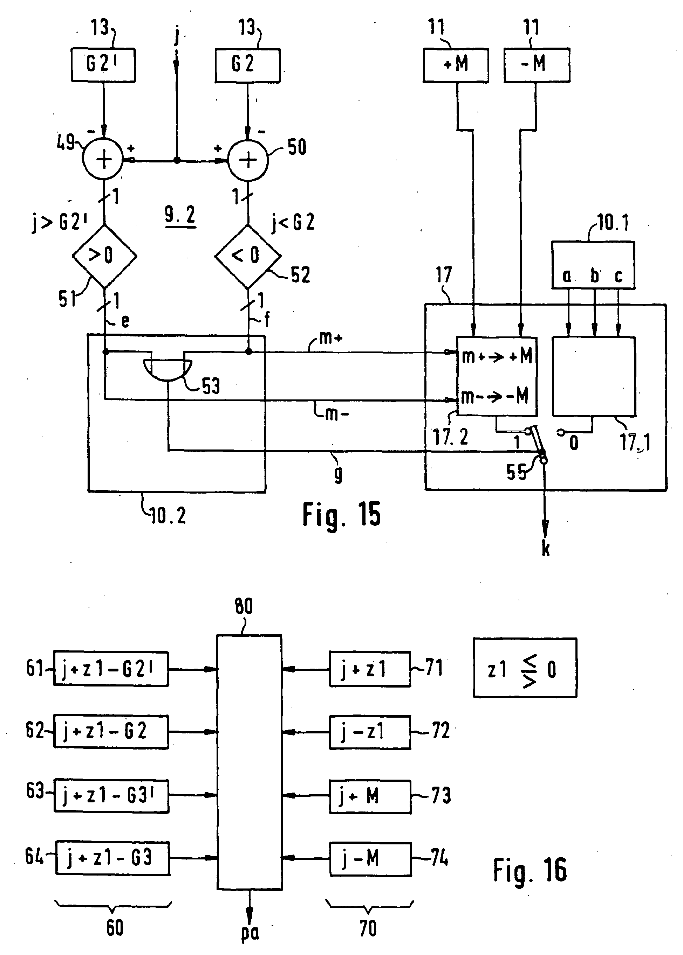

In Fig.15 ist ein anderer Vergleicher 9 dargestellt, der überprüft, ob der Testintegrationswert j innerhalb der Grenzen G3, G3' bleibt. Die Vergleichereinrichtung 9 mit dritter und vierter Recheneinheit 49, 50 und dritten und vierten Bewerter 51, 52 entspricht der Vergleichereinrichtung 9 in Fig. 13. Die zugehörigen Ausgangssignale, das fünfte und sechste Logiksignal e bzw. f sind einer Auswahleinrichtung 10.2 zugeführt, die über ein ODER-Tor 53 die Logiksignale e und f miteinender verknüpft. Das Ausgangssignal dieses Tors 53 ist ein siebtes Logiksignal g das als Steuersignal einer zweiten Teilschaltung 17.2 der Modifikationseinrichtung 17 zugeführt ist. Die Signale e und f sind als weitere Steuersignale m+ bzw. m- der Teilschaltung 17.2 zugeführt. Die erste und zweite Teilschaltung 17.1, 17.2 der Modifikationseinrichtung 17 sind mit den Signalen a, b, c bzw. mit den Signalen m+, m-gespeist. Das Logiksignal g steuert einen elektronischen Umschalter 55, der an seinem Ausgang die zu integrierende Zahl k ausgibt. In der Schalterposition "0" ist das der Ausgangswert k der Teilschaltung 17.1 und in der Schalterposition 1 ist das der positive oder negative Maximalsprung +M, -M der Teilschaltung 17.2. Die Teilschaltung 17.1 entspricht direkt der Teilschaltung 17.1von Fig. 13.

Erkennt der Vergleicher 9.2 von Fig. 15, daß die Grenzwerte G2, G2' überschritten werden, löst er die vorgesehene Rückführstrategie R aus, bei der die zu integrierende Zufallszahl z1 beispielsweise durch einen positiven oder negativen Maximalsprung +M, -M ersetzt wird. Die beiden Maximalsprünge sind im einfachsten Fall die im Speicher 11 angegebenen Grenzwerte G1, G1'. Die Auswahl, welcher der beiden Maximalsprünge durchgeführt wird, bestimmen die Steuersignale m+, m-, indem eines von beiden den logischen Zustand "1" aufweist. Wenn keine der beiden Grenzen G2, G2' überschritten wird, ist kein Maximalsprung erforderlich und beide Signale m+, m- sind im "0"-Zustand wie auch das resultierende Signal g. Der Umschalter 55 nimmt entsprechend die Schalterposition "0" ein.

Die Überprüfung sämtlicher Grenzen bringt eine Vielzahl von Additionen und Subtraktionen mit sich, die teilweise parallel ablaufen, teilweise aber auch von vorausgehenden Rechenoperationen abhängig sind und damit seriell ablaufen. Die erforderlich Zeit für die Testintegrationen kann durch die Verzögerungseinrichtung 2 oder ein Pipelineverfahren ausgeglichen werden. Eine andere Möglichkeit besteht darin, daß getrennte Recheneinheiten zu Mehrfachrecheneinheiten zusammengefaßt werden, beispielsweise indem die Recheneinheit 38 jeweils in die Recheneinheiten 42 bzw. 43 mit aufgenommen wird. Eine weitere Beschleunigung besteht darin, daß alle auftretenden Rechenvorgänge in parallelen Recheneinheiten ausgeführt werden und eine spezielle Auswahleinrichtung eines dieser Rechenergebnisse als neuen Integrationswert ausgibt. Eine derartige Anordnung ist schematisch in Fig. 16 dargestellt. Vier Mehrfachrecheneinheiten 60 und vier Einfachrecheneinheiten 70 sind an eine spezielle Auswahleinrichtung 80 angeschlossen. Der Ausgang der Auswahleinheit 80 liefert den neuen Integrationswert pa, der dann im Taktgeber 100 dem phasengesteuerten Oszillator 5 zugeführt ist. Im einzelnen werden in den parallel geschalteten Recheneinheiten 60, 70 folgende Rechenoperationen durchgeführt, wobei die zu untersuchende Zufallszahl z1 vorzeichenrichtig, also als positiver oder negativer Zahlenwert, berücksichtigt wird. Folgende Aufstellung zeigt am Beispiel des Vorzeichenumkehrverfahrens die parallel durchzuführenden Rechenoperationen in den einzelnen Recheneinheiten:

| | |
|---|---|
| Mehrfachrecheneinheit 61 | j + z1 - G2' |
| Mehrfachrecheneinheit 62 | j + z1 - G2, |
| Mehrfachrecheneinheit 63 | j + z1 - G3', |
| Mehrfachrecheneinheit 64 | j + z1 - G3, |
| Einfachrecheneinheit 71 | j + z1, |
| Einfachrecheneinheit 72 | j - z1, |
| Einfachrecheneinheit 73 | j + M |
| Einfachrecheneinheit 74 | j - M. |

### Bezugszeichenliste

- 1: Zufallszahlengenerator
- 2: Verzögerungseinrichtung
- 3: Integrator
- 4: Phasenmodulator
- 5: phasengesteuerter Oszillator
- 6: Referenzoszillator
- 7: Kontrolleinrichtung
- 8: Integratornachbildung
- 9: Vergleicher
- 9.1/9.2: erster/zweiter Vergleicher
- 10 /10.1/10.2: Auswahleinrichtung
- 11,12,13: Speicher für Grenzwerte
- 14: elektronischer Schalter
- 17: Modifikationseinrichtung
- 17.1 / 17.2: erste/zweite Teilschaltung
- 19: Datenbus
- 20: Verzögerungsstufen
- 21: abfallende Taktflanken
- 22: Anstiegsflanken
- 25: Frequenzteiler
- 30: Vielfachschalter
- 38: Recheneinheit der Integratornachbildung
- 40: Akkumulator-Recheneinheit
- 41: Akkumulator-Speicher
- 42/43: 1./2. Recheneinheit
- 44/45: 1./2. Bewerter
- 46: ODER-Tor
- 47: UND-Tor
- 48: negierender Eingang
- 49/50: 3./4. Recheneinheit
- 51 / 52: 3./4. Bewerter
- 55: elektronischer (Um-)Schalter
- 60, 61-64: Mehrfachrecheneinheiten
- 70, 71-74: Einfachrecheneinheiten
- 80: Recheneinheits-Auswahleinrichtung
- 100: Taktgeber

- A, B, B1, B1`, C, F, F`, S, S`, H, H', I, I`, J, J` K, K`, L, L`, N, N`: Diagrammpunkte
- a, b, c, d, e, f: Logiksignale
- A0: reiner, phasengesteuerter Aufenthaltsbereich
- A1, A2: 1./2. Aufenthaltsbereich
- c1, c1`: Systemtakt, Hilfstakt
- cmin: minimale Taktphase
- fcl: Frequenz des Systemtaktes
- fr: Frequenz des Ringoszillators
- g: Steuersignal, Logiksignal
- G1,G2,G3 G1`,G2,G3`: Grenzwerte
- I1, I2: 1./2. Zeitintervall
- j: Testintegrationswert
- j`: neuer Integrationswert
- j⁻¹: vorausgehender Integrationswert
- k: zu integrierende Zahl
- M, M`, M*: Maximalsprung
- m+, m-: Steuersignale für Maximalsprung
- pa: Integrationswert
- PLL: Phasenverriegelungsschleife
- ps: Phasenschritt
- pso11: Phasensollwert
- ps10`, ps7`: Überschußwert
- ps6*, ps1*: resultierender Phasenschritt
- R, +R, -R: Rückführstrategie
- t: Zeit
- T/2: halbe Taktperiode
- z1: Zufallszahl
- z2: verzögerte Zufallszahl
- z3: modifizierte Zufallszahl

## Patentansprüche

1. Taktgeber (100) mit einem Zufallszahlengenerator (1) und einem Phasenmodulator (4) zur Erzeugung eines im Frequenzspektrum verschliffenen und damit störstrahlarmen Systemtaktes (c1),
**gekennzeichnet durch** folgende Merkmale:
- zwischen den Zufallszahlengenerator (1) und den Phasenmodulator (4) ist ein Integrator (3) für die vom Zufallszahlengenerator gelieferten Zufallszahlen (z1, z2) eingefügt,
- der Ausgang des Integrators (3) steuert über seinen Integrationswert (pa; j') den jeweiligen Phasenwert im Phasenmodulator (4) und
- der Integrator (3) ist mit einer Kontrolleinrichtung (7) gekoppelt, die in die Zufallszahlen (z1, z2) oder den Integrationsvorgang des Integrators (3) eingreift, um vorgegebene Grenzwerte (G1, G1'; G2, G2'; G3 ,G3') beim Integrationswert (pa, j') nicht zu überschreiten.

2. Taktgeber (100) nach Anspruch 1, **dadurch gekennzeichnet, daß** ein erster Grenzwert (G1, G1'; cmin) und Startwert (psoll; G1 bzw. G1'; G2 bzw. G2') einen Maximalsprung (M; M'; M*) des Integrationswertes (pa; j') vorgeben, der einem maximal zulässigen Phasensprung des Systemtaktes (c1) entspricht.

3. Taktgeber (100) nach Anspruch 1, **dadurch gekennzeichnet, daß** ein zweiter Grenzwert (G2, G2') eine erste maximal zulässige Phasenabweichung des Systemtaktes (c1) mindestens während vorgegebener erster Zeitintervalle (I1) vorgibt.

4. Taktgeber (100) nach einem der Ansprüche 1 bis 3, **dadurch gekennzeichnet, daß** der Zufallszahlengenerator (1) Zufallszahlen (z1, z2) erzeugt, die innerhalb eines vorgegebenen, insbesondere durch die ersten Grenzwerte (G1, G1') definierten, Wertebereiches liegen.

5. Taktgeber (100) nach einem der Ansprüche 1 bis 4, **dadurch gekennzeichnet, daß** während zweiter Zeitintervalle (12), die insbesondere außerhalb der ersten Zeitintervalle (I1) liegen, ein dritter Grenzwert (G3, G3') eine zweite maximal zulässige Phasenabweichung des Systemtaktes (c1) vorgibt, wobei der dritte Grenzwert betragsmäßig mindestens so groß wie der zweite Grenzwert (G2, G2') ist.

6. Taktgeber (100) nach einem der Ansprüche 1 bis 5, **dadurch gekennzeichnet, daß** die Kontrolleinrichtung (7) mit einer Modifikationseinrichtung (17; 17.1; 17.2) gekoppelt ist, die zur Einhaltung des ersten, zweiten oder dritten Grenzwertes (G1, G1', G2, G2', G3, G3') die Zufallszahl (z1, z2) vor der Integration modifiziert.

7. Taktgeber (100) nach Anspruch 6, **dadurch gekennzeichnet, daß** die Modifikationseinrichtung (17) eine Teilschaltung (17.2) enthält, die eine dem dritten Grenzwert (G3, G3') zugeordnete Rückführstrategie implementiert, die sicherstellt, daß spätestens zu Beginn der ersten Zeitintervalle (I1) der Integrationswert (pa; j') wieder den zweiten Grenzwert (G2, G2') einhält.

8. Taktgeber (100) nach Anspruch 6 oder 7, **dadurch gekennzeichnet, daß** ein gegenüber dem zweiten Grenzwert (G2, G2') erweiterter Aufenthaltsbereich, der zweite Aufenthaltsbereich (A2), aus dem ersten Aufenthaltsbereich (A1) hervorgeht, indem an der oberen und/oder unteren Bereichsgrenze (G2, G2') ein Zusatzbereich angefügt ist, dessen Größe insbesondere dem Maximalsprung (M) entspricht.

9. Taktgeber (100) nach einem der Ansprüche 1 bis 8, **dadurch gekennzeichnet, daß** mindestens ein Teil der Rechenoperationen der Kontrolleinrichtung (7) und des Integrators (3) mittels parallelgeschalteter Recheneinheiten (60, 70) erfolgt und eine Recheneinheits-Auswahlschaltung (80) einen dieser Recheneinheiten auf einen Ausgang zur Abgabe eines neuen Integrationswertes (pa; j') durchschaltet.

10. Verfahren zur Erzeugung einer modifizierten Zufallszahl (z3; k), die in einem Taktgeber (100) gemäß einem der Ansprüche 1 bis 9 dem Integrator (3) anstatt einer Zufallszahl (z1, z2) zur Integration zugeführt ist, wobei in einem ersten Schritt festgestellt wird, daß mit der Zufallszahl (z1, z2) bei der Integration ein zulässiger Bereich (A0, A1, A2) überschritten wird und danach ein zweiter Schritt folgt, bei dem:
- die zu integrierende Zufallszahl (z1, z2) durch eine vorgegebene Zahl, die insbesondere einem vorgegebenen Maximalsprung M entspricht, ersetzt wird oder
- die zu integrierende Zufallszahl (z1, z2) durch eine vorgegebene Folge von Zahlen ersetzt wird oder
- der Überschußwert (ps 10`, ps7') der zu integrierenden Zufallszahl (z1, z2) an einer zugehörigen Bereichsgrenze (G1, G1', G2, G2', G3, G3') gespiegelt wird oder
- die zu integrierende Zufallszahl (z1, z2) durch eine betragsgleiche Zahl mit geändertem Vorzeichen ersetzt wird oder
- die zu integrierende Zufallszahl (z1, z2) bei Überschreitung einer dritten Bereichsgrenze (G3, G3') durch eine, insbesondere dem zulässigen Maximalsprung (M) entsprechende, vorgegebene Zahl mit passendem Vorzeichen, welche die Rückkehr in zweite Bereichsgrenzen (G2, G2') spätestens zu Beginn eines ersten Zeitintervalls (I1) ermöglicht, ersetzt wird oder
- die zu integrierende Zufallszahl (z1, z2) oder einer Folge der letzten Zufallszahlen durch eine Wiederholung der Zufallszahl oder der Folge der letzten Zufallszahlen mit Änderung mindestens eines Vorzeichens, wobei die Reihenfolge bei der Wiederholung beliebig ist, ersetzt wird oder
- die zu integrierende Zufallszahl (z1, z2) unterdrückt wird und solange neue Zufallszahlen erzeugt werden, bis eine passende Zufallszahl vorliegt, mit der die jeweiligen Bereichsgrenzen eingehalten werden.

## Claims

1. A clock generator (100) comprising a random-number generator (1) and a phase modulator (4) for generating a system clock (cl) which is jittered in the frequency spectrum and thus causes minimal radiated interference,
**characterized by** the following features:
- between the random-number generator (1) and the phase modulator (4), an integrator (3) is inserted for integrating the random numbers (z1, z2) provided by the random-number generator;
- the output of the integrator (3) controls via its integral (pa; j') the respective phase value in the phase modulator (4); and
- the integrator (3) is coupled to a checking facility (7) which interferes in the random numbers (z1, z2) or intervenes in the integration process of the integrator (3) to prevent predetermined limit values (G1, G1'; G2, G2'; G3, G3') of the integral (pa, j') from being exceeded.

2. A clock generator (100) as set forth in claim 1, **characterized in that** a first limit value (G1, G1' ; cmin) and a start value (psoll; G1, G1'; G2, G2') define a maximum jump (M; M'; M*) of the integral (pa; j') which corresponds to a maximum permissible phase shift of the system clock (cl).

3. A clock generator (100) as set forth in claim 1, **characterized in that** a second limit value (G2, G2') defines a first maximum permissible phase deviation of the system clock (cl) at least during predetermined first time intervals.

4. A clock generator (100) as set forth in any one of claims 1 to 3, **characterized in that** the random-number generator (1) produces random numbers (z1, z2) which lie within a predetermined range of values, particularly within a range defined by the first limit values (G1, G1').

5. A clock generator (100) as set forth in any one of claims 1 to 4, **characterized in that** during second time intervals, which preferably lie outside the first time intervals, a third limit value (G3, G3') defines a second maximum permissible phase deviation of the system clock (cl), the third limit value being at least equal in magnitude to the second limit value (G2, G2').

6. A clock generator (100) as set forth in any one of claims 1 to 5, **characterized in that** the checking facility (7) comprises a modification device (17; 17.1; 17.2) which modifies the random number (z1, z2) prior to the integration to meet the first, second, or third limit value (G1, G1', G2, G2', G3, G3').

7. A clock generator (100) as set forth in claim 6, **characterized in that** the modification device (17) includes a subcircuit (17.2) which implements a return strategy assigned to the third limit value (G3, G3') to ensure that the integral (pa; j') reaches the second limit value (G2, G2') again at the beginning of the first time intervals at the latest.

8. A clock generator (100) as set forth in claim 6 or 7, **characterized in that** from a first phase location range (A1), defined by the second limit values (G2, G2'), an extended phase location range, the second phase location range (A2), is formed by appending at the upper and/or lower range limits (G2, G2') an additional range, particularly a range equal in size to the maximum jump (M).

9. A clock generator (100) as set forth in any one of claims 1 to 8, **characterized in that** at least part of the arithmetic operations in the checking facility (7) and the integrator (3) are performed by means of parallel-connected arithmetic units (60, 70), and that a selection unit (80) connects one of said arithmetic units to an output for the delivery of a new integral (pa; j').

10. A method of producing a modified random number (z3; k) which is fed instead of a random number (z1, z2) to an integrator (3) in a clock generator (100) according to any one of claims 1 to 9 for integration, comprising a first step in which it is determined that a permissible range (A0, A1, A2) is exceeded with the random number (z1, z2) during the integration, and a subsequent second step, in which:
- the random number to be integrated (z1, z2) is replaced by a predetermined number, particularly a number corresponding to a predetermined maximum jump (M), or
- the random number to be integrated (z1, z2) is replaced by a predetermined number sequence, or
- the excess value (ps10', ps7') of the random number to be integrated (z1, z2) is mirrored at an associated range limit (G1, G1', G2, G2', G3, G3'), or
- the random number to be integrated (z1, z2) is replaced by a number of the same magnitude with changed sign, or
- if a third range limit (G3, G3') is exceeded, the random number to be integrated (z1, z2) is replaced by a predetermined number with appropriate sign, particularly by a number corresponding to the maximum permissible jump (M), which permits a return to second range limits (G2, G2') at the beginning of a first time interval at the latest, or
- the random number to be integrated (z1, z2) or a sequence of the last random numbers is replaced by a repetition of the random number or of the sequence of the last random numbers with at least one changed sign, with the order during the repetition being arbitrary, or
- the random number to be integrated (z1, z2) is suppressed and new random numbers are used until a suitable random number appears with which the respective range limits are met.

## Revendications

1. Générateur d'horloge (100) comportant un générateur de nombres aléatoires (1) et un modulateur de phase (4) pour la génération d'une horloge système (cl) affinée dans le spectre des fréquences et, de ce fait, à faible niveau de rayonnement perturbateur,
**caractérisé par** les caractéristiques suivantes :
- entre le générateur de nombres aléatoires (1) et le modulateur de phase (4), on insère un intégrateur (3) pour les nombres aléatoires (z1, z2) fournis par le générateur de nombres aléatoires (1),
- la sortie de l'intégrateur (3) commande, par l'intermédiaire de sa valeur d'intégration (pa ; j'), la valeur de la phase respective dans le modulateur de phase (4) et
- l'intégrateur (3) est couplé avec un dispositif de contrôle (7) qui intervient dans les nombres aléatoires (z1, z2) ou dans le processus d'intégration de l'intégrateur (3) pour ne pas dépasser des valeurs limites (G1, G1' ; G2, G2' ; G3, G3') prédéterminées pour la valeur d'intégration (pa ; j').

2. Générateur d'horloge (100) selon la revendication 1, **caractérisé en ce qu'**une première valeur limite (G1, G1' ; cmin) et une valeur de départ (psoll ; G1, resp. G1' ; G2, resp. G2') prédéterminent un saut maximal (M ; M' ; M*) de la valeur d'intégration (pa ; j') qui correspond à une saut maximal admissible de phase de l'horloge système (cl).

3. Générateur d'horloge (100) selon la revendication 1, **caractérisé en ce qu'**une deuxième valeur limite (G2 ; G2') prédétermine un premier écart maximal admissible de phase de l'horloge système (cl) au moins des premiers intervalles de temps prédéterminés (I1).

4. Générateur d'horloge (100) selon l'une quelconque des revendications 1 à 3, **caractérisé en ce que** le générateur de nombres aléatoires (1) génère des nombres aléatoires (z1, z2) qui se trouvent à l'intérieur d'un domaine de valeurs prédéterminé, en particulier défini par les premières valeurs limites (G1, G1').

5. Générateur d'horloge (100) selon l'une quelconque des revendications 1 à 4, **caractérisé en ce que**, pendant des deuxièmes intervalles de temps (12), qui se trouvent, en particulier, à l'extérieur des premiers intervalles de temps (11), il se produit un deuxième écart maximal admissible de phase de l'horloge système (cl) et **en ce que** la troisième valeur limite (G3, G3') est, en ce qui concerne sa valeur, au moins aussi grande que la deuxième valeur limite (G2, G2').

6. Générateur d'horloge (100) selon l'une quelconque des revendications 1 à 5, **caractérisé en ce que** le dispositif de contrôle (7) est couplé avec un dispositif de modification (17 ; 17.1 ; 17.2) qui, pour le maintien des premières, deuxièmes et troisièmes valeurs limites (G1, G1' ; G2, G2' ; G3, G3'), modifie le nombre aléatoire (z1, z2) avant l'intégration.

7. Générateur d'horloge (100) selon la revendication 6, **caractérisé en ce que** le dispositif de modification (17) contient un circuit partiel (17.2) qui implémente une stratégie de contre-réaction qui est associée à la troisième valeur limite (G3, G3') et qui assure que, au moins au début du premier intervalle de temps (11), la valeur d'intégration (pa ; j') contient de nouveau la deuxième valeur limite (G2, G2').

8. Générateur d'horloge (100) selon la revendication 6 ou 7, **caractérisé en ce qu'**un domaine de séjour élargi par rapport à la deuxième valeur limite (G2, G2'), le deuxième domaine de séjour (A2), est obtenu à partir du premier domaine de séjour (A1), par le fait que l'on ajoute, aux limites de domaine supérieure et/ou inférieur (G2, G2'), un domaine additionnel dont la grandeur correspond en particulier au saut maximal (M).

9. Générateur d'horloge (100) selon l'une quelconque des revendications 1 à 8, **caractérisé en ce qu'**au moins une partie des opérations de calcul du dispositif de contrôle (7) et de l'intégrateur (3) est réalisée d'unités de calcul (60, 70) branchées en parallèle et **en ce qu'**un circuit de commutation sélective d'unité de calcul (80) commute une de ces unités de calcul (60, 70) sur une sortie pour fournir une nouvelle valeur d'intégration (pa ; j').

10. Procédé pour la génération d'un nombre aléatoire modifié (z3 ; k) qui, dans un générateur d'horloge (100) selon l'une quelconque des revendications 1 à 9, est envoyé à l'intégration à la place d'un nombre aléatoire (z1, z2), procédé dans lequel, dans une première étape, on détermine que, avec le nombre aléatoire (z1, z2), on dépasse, lors de l'intégration, un domaine admissible (A0, A1, A2) et que se produit ensuite une deuxième étape :
- on remplace le nombre aléatoire (z1, z2) à intégrer par un nombre prédéterminé qui correspond, en particulier, à un saut maximal prédéterminé (M) ou
- on remplace le nombre aléatoire (z1, z2) à intégrer par une suite prédéterminée de nombres ou
- la valeur du dépassement (ps10', ps7') du nombre aléatoire (z1, z2) à intégrer est symétrisé à une limite de domaine associée (G1, G1', G2, G2', G", G3') ou
- on remplace le nombre aléatoire (z1, z2) à intégrer par un nombre de même valeur ayant un signe algébrique modifié ou
- on remplace le nombre aléatoire (z1, z2) à intégrer, lors du dépassement d'une troisième limite de domaine (G3, G3'), par un nombre prédéterminé qui correspond, en particulier, au saut maximal admissible (M) avec un signe algébrique qui convient et qui permet le retour dans des deuxièmes limites de domaines (G2, G2'), au plus tard au début d'un premier intervalle de temps (I1) ou
- on remplace le nombre aléatoire (z1, z2) à intégrer ou une suite des derniers nombres aléatoires par une répétition du nombre aléatoire ou la suite des derniers nombres aléatoires en modifiant au moins un signe algébrique, la séquence de la suite étant arbitraire lors de la répétition ou
- on supprime le nombre aléatoire (z1, z2) à intégrer tant que de nouveaux nombres aléatoires sont générés jusqu'à ce qu'il y ait un nombre aléatoire qui convient et au moyen duquel on maintient les limites de domaine respectives.
